# EUROPEAN PATENT APPLICATION

(11) **EP 3 444 850 A1**
(43) Date of publication of application: **20.02.2019**
(21) Application number: 17782336.6
(22) Date of filing: 10.04.2017
(51) Int. Cl.: H01L 31/05, H01L 31/054

(54) **SOLAR CELL WIRING MEMBER AND SOLAR CELL MODULE**

(30) Priority: 14.04.2016 JP 2016081075
(71) Applicant: Kaneka Corporation, Osaka 5308288 (JP)
(72) Inventor: KOIZUMI, Gensuke, Settsu-shi Osaka 5660072 (JP); TERASHITA, Toru, Settsu-shi Osaka 5660072 (JP); UZU, Hisashi, Settsu-shi Osaka 5660072 (JP)
(74) Representative: V.O.
(86) International application number: PCT/JP2017/014632
(87) International publication number: WO 2017/179523

(57) **Abstract**

A band-like wiring member (80) has a plurality of projected parts (85) having a triangular cross section in a part of a first main surface which is connected to a solar cell. The plurality of projected parts extend in parallel, and the extending direction thereof is non-parallel to a longitudinal direction of the wiring member. A solar cell module is obtained by electrically connecting a plurality of solar cells having metal electrodes on a light-receiving surface and a back surface via the wiring member. When electrically connecting a plurality of solar cells using the wiring member (80), the projected part formed surface of the wiring member is preferably bonded to the light-receiving- surface metal electrode or the back-surface metal electrode of the solar cells via a conductive film.

## Description

### TECHNICAL FIELD

The present invention relates to a wiring member for connecting a plurality of solar cells, and a solar cell module.

### BACKGROUND ART

Solar cells that include crystalline semiconductor substrates such as a single-crystalline silicon substrate and a polycrystalline silicon substrate have a small area for one substrate, and thus in practical use, a plurality of solar cells are electrically connected and modularized for increasing output. For the electrical connection of the plurality of solar cells, a wiring member referred to as a tab wire is used, and the wiring member is connected by solder or the like to electrodes disposed on the light-receiving surfaces and back surfaces of the solar cells.

For the purpose of increasing the amount of light taken into solar cells by light scattering reflection, Patent Document 1 and Patent Document 2, etc. propose using a wiring member having uneven surface for electrically connecting solar cells.

### PRIOR ART DOCUMENTS

### PATENT DOCUMENTS

Patent Document 1: JP 2006-13406 A
Patent Document 2: JP 2009-10222 A

### SUMMARY OF THE INVENTION

### PROBLEMS TO BE SOLVED BY THE INVENTION

Conductive films have been used instead of solders for connecting the wiring member and electrodes of the solar cells. The connections with the conductive films can be performed at lower temperature than the solder connections, thus have advantages such as being capable of keeping cells from being warped and cracked due to heat for connection. On the other hand, the conductive films, which are higher in material cost than solders, are thus required to achieve high adhesiveness and bonding reliability while reducing the amounts used.

In view of the foregoing, an object of the present invention is to provide a solar cell wiring member, which is excellent in adhesiveness to a solar cell and bonding reliability even when the used amount of an adhesive material such as a conductive film is small.

### MEANS FOR SOLVING THE PROBLEMS

The present invention relates to a band-shaped wiring member for use in electrically connecting a plurality of solar cells. The wiring member has a plurality of projected parts each having a triangular in cross section at a part connected to a solar cell at least on one surface. The plurality of projected parts extends parallel, and an extending direction of each of the plurality of projected parts is non-parallel to a longitudinal direction of the wiring member. An angle φ made by the extending direction of each of the projected parts and the longitudinal direction of the wiring member is preferably 40° to 90°.

Each of the projected parts of the wiring member preferably has an isosceles triangle cross-sectional shape in a plane perpendicular to the extending direction. An elevation angle (base angle in the cross section) θ of a slope of each of the projected parts is preferably 20° to 40°.

The projected parts may be also provided at the other part besides the part connected to a solar cell, and may be provided over an entire surface. In addition, both surfaces of the wiring member may have projected parts.

When the projected parts are provided on both surfaces of the wiring member, the extending direction of each of the projected parts provided on one surface and the extending direction of each of the projected parts provided on the other surface are preferably parallel, or symmetrical with respect to the longitudinal direction of the wiring member.

Furthermore, the present invention relates to a solar cell module including a plurality of solar cells each having electrodes on a light-receiving surface and a back surface, and the plurality of solar cells are electrically connected by the wiring member mentioned above. In one embodiment, an electrode connected to the projected part formed surface of the wiring member has a linear shape extending parallel to the longitudinal direction of the wiring member, and an electrode width is 70% or less of a width of the wiring member. The wiring member is preferably connected to the electrode of each of the solar cells via a conductive film.

### EFFECTS OF THE INVENTION

With the projected parts extending non-parallel to the longitudinal direction of the wiring member, the conductive film tends to expand between the projected parts (*i.e*., recessed parts) in the extending direction of the projected parts, when the wiring member and the solar cell are connected with the use of the conductive film. Therefore, even when the conductive film is small in width, the bonding can be achieved entirely in the width direction of the wiring member, thereby enhancing the reliability of connection between the solar cell and the wiring member.

The longitudinal direction of the wiring member is non-parallel to the extending direction of the projected part, and thus, even in the case of connecting the projected part formed surface of the wiring member to a linear electrode, the area of contact between the electrode of the solar cell and the wiring member can be ensured. Therefore, even when the electrode width of the solar cell is small, it is possible to achieve a favorable electrical connection between the electrode and the wiring member, it is not necessary to form the electrode in a zigzag shape, and thus the electrode material cost can be reduced.

### BRIEF DESCRIPTION OF THE DRAWINGS

FIG. 1 is a schematic cross-sectional view illustrating a solar cell module according to one embodiment.
FIG. 2 is a schematic cross-sectional view of a solar cell.
FIG. 3 is a plan view of a solar cell.
FIG. 4 is a schematic perspective view of a wiring member according to one embodiment.
FIG. 5A is a plan view of an uneven formed surface of a wiring member.
FIG. 5B is a cross-sectional view in a direction perpendicular to the extending direction of projected parts of the wiring member.
FIG. 6 is a schematic perspective view of a wiring member according to one embodiment.
FIG. 7 is a schematic perspective view for explaining the extending direction of projected parts of a wiring member in a solar cell string.
FIG. 8 is a conceptual diagram for explaining a connection between a fine-wire bus bar electrode and a wiring member according to the prior art.
FIG. 9 is a conceptual diagram for explaining a connection between a fine-wire bus bar electrode and a wiring member.

### MODE FOR CARRYING OUT THE INVENTION

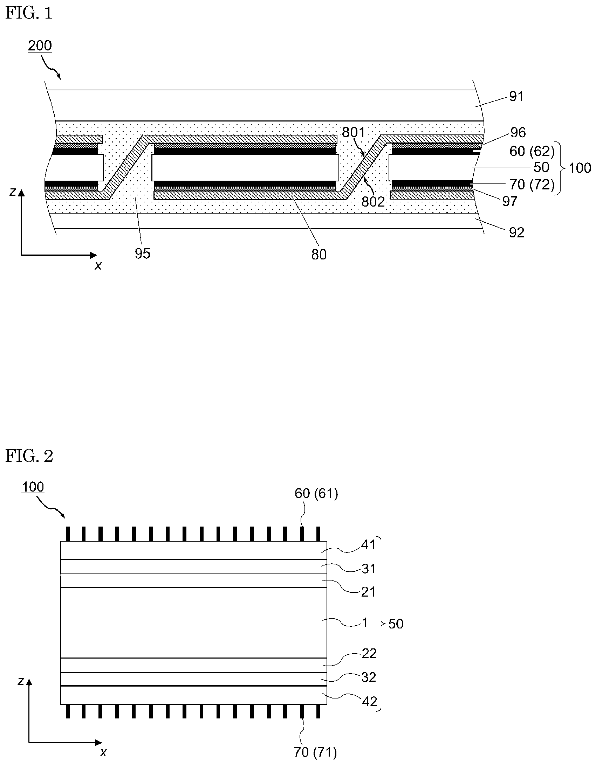

FIG. 1 is a schematic sectional view of a solar cell module (hereinafter referred to as a "module"). A module 200 includes a plurality of solar cells 100 (hereinafter referred to as "cells"). The cell 100 includes metal electrodes 60 and 70 respectively on the light-receiving surface and back surface of a photoelectric conversion section 50. As shown in FIG. 1, the upper and lower metal electrodes 60 and 70 of the adjacent cells are connected via a wiring member 80 to form a solar cell string that has a plurality of cells electrically connected.

A light-receiving-surface protection member 91 is disposed on the light-receiving side (the upper side in FIG. 1) of the solar cell string, and a back-surface protection member 92 is disposed on the back side (the lower side in FIG. 1) of the solar cell string. In the module 200, the solar cell string is encapsulated by filling the space between the protection members 91 and 92 with an encapsulant 95.

As the cell 100, a type of solar cells that are configured to be interconnected with a wiring member can be used, such as a crystalline silicon solar cell or a solar cell including a semiconductor substrate other than silicon such as GaAs. FIG. 2 is a schematic cross-sectional view illustrating an embodiment of the cell 100. The photoelectric conversion section 50 includes a crystalline semiconductor substrate 1. The crystalline semiconductor substrate may be single-crystalline or polycrystalline, and a single-crystalline silicon substrate, a polycrystalline silicon substrate, or the like is preferred. It is preferable that irregularities on the order of about 1 to 10 µm in height are formed on the surface on the light-receiving side of the crystalline semiconductor substrate 1. Irregularities at the light-receiving surface increases the light-receiving area and decreases the reflectance, thus enhancing the optical confinement efficiency. The back side of the substrate may also have irregularities.

The cell 100 shown in FIG. 2 is a so-called heterojunction cell, which includes an intrinsic amorphous silicon thin-film 21, a p-type amorphous silicon thin-film 31, and a transparent conductive film 41 in this order on the light-receiving side of the n-type single-crystalline silicon substrate 1, and an intrinsic amorphous silicon thin-film 22, an n-type amorphous silicon thin-film 32, and a transparent conductive film 42 in this order on the back side.

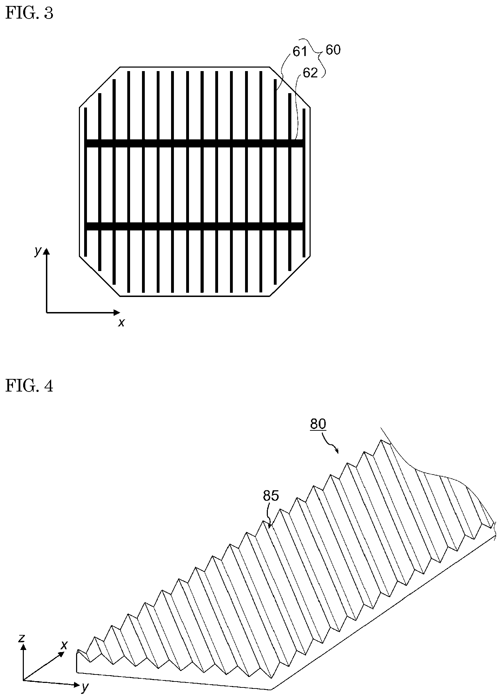

A light-receiving-side metal electrode 60 is disposed on the transparent conductive film 41, and a back-side metal electrode 70 is disposed on the transparent conductive film 42. The light-receiving-side metal electrode 60 has a specific pattern shape, and light can be captured from a section where no metal electrode is disposed. The pattern shape of the metal electrode 60 is not particularly limited, and is preferably a grid form including a plurality of finger electrodes 61 arranged in parallel and bus bar electrodes 62 extending perpendicular to the finger electrodes, as shown in FIG. 3. The width of the finger electrode 61 is typically about 10 to 100 µm. The width of a typical bus bar electrode is substantially equal to the width of the wiring member (about 0.8 to 1.2 times), which is about 0.5 to 3 mm. As will be described later, the wiring member according to the present invention can achieve a favorable electrical connection with a bus bar electrode (fine-wire bus bar electrode) which is smaller in width than the wiring member. The back-side metal electrode 70 may have a pattern shape like the light-receiving-side metal electrode, or may be disposed over the entire surface on the photoelectric conversion section.

In the module 200, one surface 801 of the wiring member 80 is connected to the back-side metal electrode 70 of the cell, whereas the other surface 802 is connected to the light-receiving-side metal electrode 60 of the adjacent cell. Electroconductive materials 96, 97 for bonding the metal electrodes 60, 70 and the wiring member 80 are disposed between the metal electrodes 60, 70 and the wiring member 80. As the electroconductive material, a solder, an electroconductive adhesive, a conductive film, or the like is used.

### <Wiring Member>

The solar cell wiring member according to the present invention has a band shape extending in one direction, and has an uneven structure at the surface of a connection to the electrode of the cell (the surface facing the cell for connection). FIG. 4 is a perspective view of the wiring member 80 according to one embodiment of the present invention. The wiring member 80 has a band shape extending in the x direction, and has a plurality of projected parts 85 at one principal surface. The projected part 85 extends in one direction, and has a triangle cross-sectional shape in a cross section perpendicular to the extending direction. More specifically, the projected part 85 has a triangular prism shape. The plurality of projected parts 85 is arranged in parallel, and the extending direction of the projected part is non-parallel to the longitudinal direction (x direction) of the wiring member.

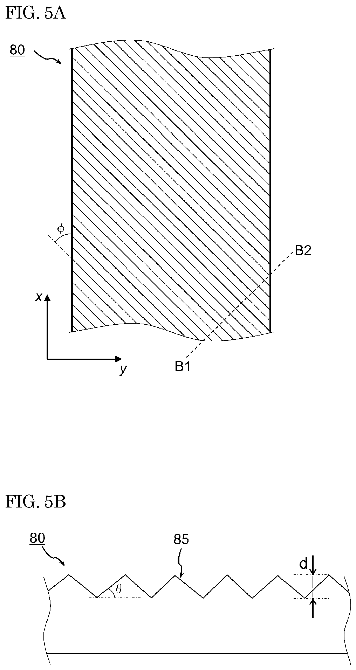

FIG. 5A is a plan view of the uneven formed surface of the wiring member 80. The extending direction of the projected part 85 has an angle φ made with respect to the longitudinal direction of the wiring member. FIG. 5B is a cross-sectional view taken in a direction (along the line B1-B2 in FIG. 5A) perpendicular to the extending direction of the projected part 85. As shown in FIG. 5B, the projected part 85 of the wiring member preferably has an isosceles triangle cross-sectional shape in a plane perpendicular to the extending direction.

It is preferable to use an electroconductive adhesive for connecting the projected part formed surface of the wiring member and the cell. When the wiring member has projected parts extending non-parallel to the longitudinal direction at the surface of the connection to the cell, there is a tendency for a conductive film to expand (flow) in the extending direction of the projected part in thermocompression-bonding of the wiring member and the cell with the conductive film interposed therebetween. Therefore, even when the conductive film is small in width, the bonding can be achieved entirely in the width direction of the wiring member, thereby enhancing the reliability of connection between the cell and the wiring member. In addition, the width of the conductive film required for the bonding can be reduced, thus also making a contribution to reduction in material cost.

As the angle made by the longitudinal direction of the wiring member and the extending direction of the projected part is increased, the conductive film is more likely to expand in the width direction, and there is a tendency to enhance the bonding strength and the bonding reliability. Therefore, the angle φ made by the longitudinal direction of the wiring member and the extending direction of the projected part is 40° or more. The upper limit of φ is 90°.

The height d of the projected part is preferably 5 to 100 µm, and more preferably 10 to 80 µm. The elevation angle of a slope of the projected part (which is the elevation angle of an oblique side of the triangle in a cross section perpendicular to the extending direction, and the base angle when the sectional shape is an isosceles triangle) θ is preferably 20 to 40°. As long as the height of the projected part (the depth of the recessed part) d and elevation angle θ of the projection fall within the ranges mentioned above, the electroconductive adhesive is likely to flow between the projected parts, and there is a tendency for the adhesiveness with the electroconductive adhesive to be enhanced. The width of the wiring member is selected depending on the electrode configuration of the cell (for example, the width and number of bus bars), and typically about 0.5 to 3 mm.

The surface of the wiring member other than the connection to the cell may have an uneven structure similar to that of the connection. The uneven structure is preferably formed entirely over one surface of the wiring member, *i.e*., over the entire length in the longitudinal direction of the wiring member, since the formation of the wiring member and the alignment in the longitudinal direction for connection to the cell can be easily achieved.

When the wiring member has unevenness at the connection surface 801 to the back-side metal electrode 70, *i.e.,* the light-receiving surface, light is scattered and reflected by the unevenness at the surface of the wiring member, and there is thus a tendency for the light utilization efficiency of the solar cell module to be improved. When the light-receiving surface of the wiring member has projected parts extending non-parallel to the longitudinal direction of the wiring member, light from various angles (azimuth and altitude) can be scattered and reflected, and the light reflected again by the light-receiving-surface protection member can be taken into the cell. Therefore, the full-year module conversion efficiency can be improved. In order to take the light reflected by the wiring member efficiently into the cell, the angle φ made by the longitudinal direction of the wiring member and the extending direction of the projected part is preferably 40 to 50°.

The angle of the projected part at the surface of the wiring member may vary depending on the position of the wiring member. As mentioned previously, in order to improve the adhesiveness between the wiring member and the electrode of the cell with the electroconductive adhesive interposed therebetween, the angle φ made by the longitudinal direction of the wiring member and the extending direction of the projected part is preferably large (close to 90°). On the other hand, φ is preferably 40° to 50° in order to increase the efficiency of making the reflected light at the surface of the wiring member incident again onto the cell. For example, the adhesiveness and the re-incidence efficiency of reflected light can be both optimized as long as the projected parts are formed such that φ is larger than 50° at a part that is connected to the cell for modularization, and φ of a part that is not connected to the cell (a part where the opposite surface is connected to the cell) is 40° to 60°.

The material of the wiring member is preferably low in resistance. From the viewpoint of low cost, materials containing copper as their main constituent are particularly preferably used. In order to increase the amount of light reflected by the uneven structure at the surface of the wiring member, it is preferable for the surface of the wiring member to be coated with a highly light reflective material such as gold, silver, copper, or aluminum.

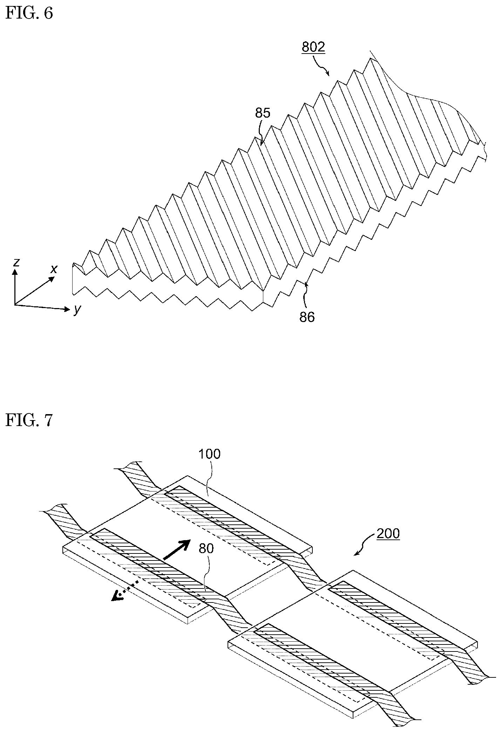

As shown in FIG. 6, both surfaces of the wiring member may have unevenness. As can be also understood from FIG. 2, the wiring member 80 has one surface 801 connected to the back-side metal electrode 70 of the cell, and the other surface 802 connected to the light-receiving-side metal electrode 60 of the adjacent cell. Therefore, as long as both surfaces of the wiring member have unevenness, the adhesiveness to both the light-receiving-side metal electrode 60 and the back-side metal electrode 70 as well as the bonding reliability can be improved.

When both surfaces of the wiring member have unevenness, the shape of the unevenness on the upper and lower sides may be the same or different. From the viewpoint of enhancing the adhesiveness to the metal electrode, it is preferable to provide projected parts in the shape of a triangular prism on both surfaces of the wiring member, where the extending direction of the projected part is non-parallel to the longitudinal direction of the wiring member. In addition, for each of the extending directions of the projected parts on both surfaces, the angle φ made with respect to the longitudinal direction of the wiring member is preferably 40° to 90°.

Considering the stress balance between the upper and lower sides for connection to the solar cell, the projected parts on the upper and lower sides of the wiring member preferably have the same shape. In addition, the extending directions of the projected parts on the upper and lower sides of the wiring member are preferably parallel, or symmetrical with respect to the longitudinal direction of the wiring member. The phrase of being symmetrical with respect to the longitudinal direction of the wiring member means that when the angle of the extending direction of the projected part provided on one surface is φ, the angle of the extending direction of the projected part provided on the other surface is -φ.

FIG. 7 is a schematic perspective view of a solar cell string where a plurality of cells 100 is connected by a wiring member 80. In the embodiment shown in FIG. 7, the wiring member 80 has projected parts on both surfaces, and the projected parts on the upper and lower sides of the wiring member have parallel extending directions. The extending direction of the projected part at the surface of the wiring member 80 facing the cell, with the wiring member connected to the light-receiving surface of the cell 100 is parallel to the extending direction of the projected part at the surface of the wiring member facing the cell, with the wiring member connected to the back surface.

When the module undergoes a temperature change, the cell and the wiring member undergo a volume change. Generally, the metallic material of the wiring member has a higher thermal expansion coefficient than the crystalline silicon substrate, and thus, as the temperature rises, stress caused by the thermal expansion of the wiring member is generated at the interface between the cell and the wiring member. FIG. 7 schematically shows the stress generated at the light-receiving surface of the cell when the temperature rises (when the wiring member is thermally expanded) as a solid line, and the stress generated at the back surface as a dotted line.

When the extending direction of the projected part of the wiring member in contact with the light-receiving surface of the cell is parallel to the extending direction of the projected part of the wiring member that is in contact with the back surface of the cell, as shown in FIG. 7, the directions of the stresses are opposite to each other on the upper and lower sides of the cell, and the both stresses have an action of canceling each other. When the temperature decreases, stresses in the directions opposite to the arrows in FIG. 7 are applied, and the stresses on the upper and lower sides of the cell thus have an action of canceling each other as in the case of temperature rise. Therefore, there is a tendency to keep the cell from being warped and thermally cracked by temperature changes.

### <Preparation of Solar Cell Module>

In the preparation of the module, first, a solar cell string is prepared which has the plurality of cells 100 connected to each other via the wiring member 80.

When only one surface 801 (first principal surface) of the wiring member 80 serve as a projected part formed surface, the projected part formed surface is preferably connected to the back-side metal electrode 70. As mentioned previously, when the wiring member has an unevenness at the light-receiving surface, light is scattered and reflected by the wiring member, and the light utilization efficiency of the solar cell module can be thus improved. When both surfaces (the first principal surface and the second principal surface) of the wiring member serve as projected part formed surfaces, the light-receiving-side metal electrode 60 and the back-side metal electrode 70 are respectively connected to the projected part formed surfaces of the wiring member. As mentioned above, when the projected part formed surface of the wiring member is connected to the electrode of the solar cell 100 via the conductive film, the width of the conductive film required for the bonding can be reduced, and the material cost can be thus reduced.

When the metal electrode is formed in a pattern shape, the wiring member is connected onto the bus bar electrode. The width of a bus bar electrode of a typical solar cell is substantially equal to the width of the wiring member. On the other hand, since a silver paste or the like used for formation of the bus bar electrode is expensive and thus material cost is high, a "fine-wire bus bar" structure is proposed where the width of the bus bar electrode is reduced. The width of the fine-wire bus bar electrode is about 50 to 1000 µm. The electrode width of the fine-wire bus bar electrode is 70% or less, preferably 3 to 50%, more preferably 5 to 40% of the width of the wiring member. The material cost can be reduced by decreasing the width of the bus bar electrode. Increasing the cross-sectional area of the wiring member connected to the bus bar electrode can cause the wiring member to serve to transport carriers in the extending direction (x direction) of the bus bar electrode, and thereby suppressing the increase in series resistance.

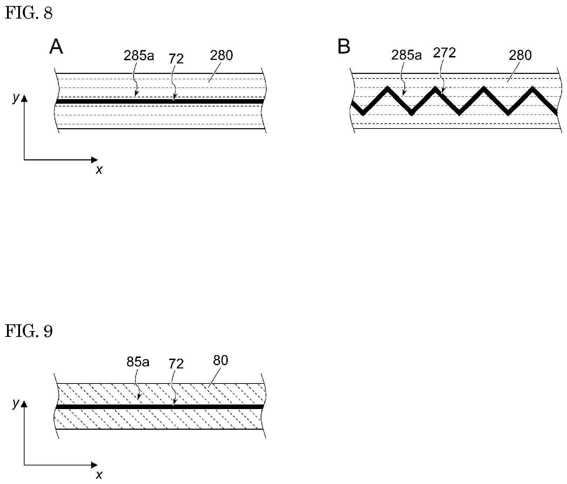

In the fine-wire bus bar structure, the wiring member serves as a main carrier transportation path, so that the electrical connection between the bus bar electrode and the wiring member is important in order to reduce the electrical loss due to resistance. When a wiring member 280 with projected parts extending parallel to the longitudinal direction is used, the resistance may be increased in some cases without any contact between vertexes 285a (dotted line in the drawing) of the projected parts and a linear bus bar electrode 72 as shown in FIG. 8A. In order to ensure the area of contact between the vertexes 285a of the projected parts of the wiring member and the bus bar electrode, it is necessary to form a bus bar electrode 272 in a zigzag shape as shown in FIG. 8B. Since the electrode area of the zigzag-shaped bus bar electrode 272 is larger as compared with that of the linear bus bar electrode 72, the used amount of a material such as silver paste is increased, which leads to an increase in material cost.

When the longitudinal direction of the wiring member 80 is non-parallel to the extending direction of the projected part, the area of contact between the linear bus bar electrode 72 extending parallel to the longitudinal direction of the wiring member and vertexes 85a of the projected parts can be ensured as shown in FIG. 9. Therefore, the wiring member according to the present invention is capable of achieving a favorable electrical connection to a linear fine-wire bus bar electrode, which can contribute to a reduction in the electrode material cost of the solar cell.

The fine-wire bus bar is not required to be uniform in width, and may have parts that differ in width (for example, parts that have a width larger than 70% of the width of the wiring member) in the extending direction. The electrical connectivity and adhesion to the wiring member can be improved by locally providing a wide part.

The solar cell string with the plurality of cells 100 connected to each other via the wiring member 80 is sandwiched between the light-receiving-surface protection member 91 and the back-surface protection member 92 via the encapsulant 95, thereby forming the solar cell module. It is preferable to cure the encapsulant by heating, under predetermined conditions, the stacked body where the light-receiving surface encapsulant, the solar cell string, the back surface encapsulant, and the back-surface protection member are placed in order on the light-receiving-surface protection member.

As the protecting member 91 on the light-receiving side, light-transmissive and water-permeable material such as glass or light-transmissive plastic can be used. As the protecting member 92 on the back side, a resin film of polyethylene terephthalate (PET) or the like, or a laminated film having a structure in which an aluminum foil is sandwiched between resin films can be used. As the encapsulant 95, a transparent resin such as high-density polyethylene (HDPE), high-pressure low-density polyethylene (LDPE), linear low-density polyethylene (LLDPE), polypropylene (PP), ethylene/α-olefin copolymer, ethylene/vinyl acetate copolymer (EVA), ethylene/vinyl acetate/triallyl isocyanurate (EVAT), polyvinyl butyrate (PVB), silicon, urethane, acryl or epoxy is preferably used.

### EXAMPLES

The present invention will be described more specifically below by comparing Examples and Comparative Examples, but the present invention is not limited to these examples.

### [Preparation of Solar Cell]

On the light-receiving side of a 6-inch-size (semi-square type with a side length of 156 nm) 160-µm-thick n-type single-crystalline silicon substrate having pyramidal projections on both surfaces, a 4-nm-thick intrinsic amorphous silicon layer and a 6-nm-thick p-type amorphous silicon layer were formed by a plasma-enhanced CVD method. Thereafter, on the back side of the silicon substrate, a 5-nm-thick intrinsic amorphous silicon layer and a 10-nm-thick n-type amorphous silicon layer were formed by a plasma-enhanced CVD. A 100-nm-thick ITO layer was formed by a sputtering method on each of the p-layer and the n-layer, followed by formation of a plated copper electrode on each of the ITO layers by the method described in the example of WO2013/077038, to obtain a heterojunction solar cell. As for the copper electrode pattern, the light-receiving surface and the back surface both are provided with three bus bar electrodes each having 1.5-mm-width, and the number of finger electrodes on the back side is made twice as large as the number of finger electrodes for the light-receiving-side metal electrode.

### [Peel Strength Test of Wiring Member]

A 25-µm-thick conductive film was placed on the bus bars of the light-receiving surface of the solar cell obtained as mentioned above, and a wiring member with a width of 1.5 mm was placed thereon, followed by thermocompression bonding to obtain a sample for a peel strength test. In Examples 1 to 4 and Comparative Examples 1 and 2, a wiring member was used that had, on both surfaces of the wiring member, an uneven shape of triangular prism-shaped projected parts arranged in parallel, where the cross-sectional shape of the projected part was an isosceles triangle (height 50 µm, base angle θ = 30°).

The angle made by the extending direction of the projected part and the longitudinal direction of the wiring member is shown in Table 1. In Comparative Examples 3 and 4 and Reference Example, a wiring member with a smooth surface was used. Ten samples were prepared for each of the Examples, Comparative Examples, and Reference Example.

With use of a peel strength tester (MX-2000N manufactured by IMADA Co., Ltd.), the wiring members were subjected to a 90° peeling test at a speed of 40 mm/min, and the wiring members with a maximum load for peeling (peel strength) equal to or higher than a standard strength was determined to be acceptable, thereby figuring out the acceptance rate. Table 1 shows the extending directions of the projected parts of the wiring members used for the Examples, Comparative Examples, and Reference Example, the widths of the conductive films, and the acceptance rates in the peel strength test.

**Table 1**

| | Projected part extending direction φ (°) | Conductive film width (mm) | Peel strength test acceptance rate (%) |
|---|---|---|---|
| Example1 | 45 | 1.0 | 100 |
| Example2 | 45 | 0.9 | 100 |
| Example3 | 90 | 1.0 | 100 |
| Example4 | 90 | 0.9 | 100 |
| Comparative Example 1 | 0 | 1.0 | 60 |
| Comparative Example 2 | 0 | 0.9 | 20 |
| Comparative Example 3 | No projected part | 1.0 | 70 |
| Comparative Example 4 | No projected part | 0.9 | 50 |
| Reference Example | No projected part | 1.2 | 100 |

### [Preparation of Solar Cell Module and Temperature Cycle Test]

Wiring members were connected onto the bus bars on the light-receiving surface and back surface of the solar cells obtained as mentioned above, thereby preparing solar cell strings each composed of nine solar cells connected in series. The interval between adjacent cells was set to 2 mm, and the combination of the wiring member and the conductive film was adopted in the same manner as in Example 1, Comparative Example 1 and Comparative Example 3 (the respective standards are considered as Example 5, Comparative Example 5, and Comparative Example 6).

On a white glass plate as a light-receiving-surface protection member, an EVA sheet was placed, the solar cell strings mentioned above were arranged thereon in 6 rows so that the distance between adjacent strings was 2 mm, and electrical connections were made at ends, thereby connecting 54 solar cells in total in series. An EVA sheet as a back side encapsulant was placed thereon, and a white light-reflective back sheet as a back-surface protection member, in which a white resin layer is disposed on a base PET film, was placed on the back side encapsulant. After thermocompression bonding at atmospheric pressure for 5 minutes, the EVA was made cross-linked by keeping at 150°C for 20 minutes, thereby providing a solar cell module.

After measuring the initial power generation characteristics (short circuit current Isc, open circuit voltage Voc, fill factor FF, and maximum output Pmax) of the solar cell module, a temperature cycle test was carried out in accordance with JIS C 8917. For the temperature cycle, after introducing the solar cell module into a test tank, holding at 90°C for 10 minutes, cooling down to -40°C at 80°C/min, holding at -40°C for 10 minutes, and temperature rise up to 90°C at 80°C/min were regarded as one cycle, and 200 cycles were carried out. The output of the solar cell module after the temperature cycle test was measured again, thereby determining the ratio (retention rate) of the power generation characteristics after the 200 cycles to the initial power generation characteristics of the solar cell module. The results are shown in Table 2.

**Table 2**

| | Projected part extending direction φ(°) | Conductive film width (mm) | Retention rate after temperature cycle test | | | |
|---|---|---|---|---|---|---|
| | | | Isc (%) | Voc (%) | FF (%) | Pmax (%) |
| Example 5 | 45 | 1.0 | 99.8 | 99.5 | 99.4 | 98.7 |
| Comparative Example | 0 | 1.0 | 99.7 | 99.5 | 94.9 | 94.1 |
| Comparative Example 6 | No projected part | 1.0 | 99.9 | 99.5 | 98.0 | 97.4 |

In Comparative Example 3 in which the 1.0-mm-width wiring member was connected with using 1.5-mm-width conductive film, the acceptance rate in the peel strength test was 70%. The acceptance rate was decreased to 50% when the width of the conductive film was reduced to 0.9 mm. In order to achieve the acceptance rate of 100%, the width of the conductive film was required to be increased up to 1.2 mm as in the Reference Example.

In Comparative Example 1 and Comparative Example 2 where the wiring members with the projected parts extending parallel to the longitudinal directions were used, the acceptance rates were further lower than those in Comparative Examples 3 and 4. This is believed to be because the projected parts extending in the longitudinal directions of the wiring members interfere with the flows of the conductive film in the width direction.

In Example 1 where the wiring member with the projected parts extending in the direction of 45° with respect to the longitudinal direction was used, the acceptance rate in the peeling test was 100% in the case of using the 1.0-mm-width conductive film, and even in Example 2 where the width of the conductive film was reduced to 0.9 mm, the acceptance rate of 100% was maintained. Similar results were obtained in Examples 3 and 4 where the wiring members with projected parts extending in directions perpendicular to the longitudinal directions were used. From these results, it is understood that use of the wiring member with projected parts extending non-parallel to the longitudinal direction can exert a high adhesive force even when the width of the conductive film is reduced, thus allowing the used amount of the conductive film to be reduced.

In Table 2, although no clear difference was found in the retention rates of Isc and Voc after the temperature cycle test, a remarkable difference was found in FF. In Example 5 in which the wiring member with projected parts extending non-parallel to the longitudinal direction was used, the retention rate of FF after the temperature cycle test was higher as compared with Comparative Examples 5 and 6, and accordingly, the high retention rate of Pmax was exhibited. The decreases in retention rate of FF in Comparative Example 5 and Comparative Example 6 are believed to be caused by the decreased adhesion of the wiring member, peeling, or the like.

From the foregoing results, it is understood that use of the wiring member with projected parts extending non-parallel to the longitudinal direction enhances the adhesiveness between the wiring member and the solar cells with the conductive film interposed therebetween, and the bonding reliability, thereby providing a solar cell module with excellent reliability.

### DESCRIPTION OF REFERENCE CHARACTERS

- 1: crystalline semiconductor substrate
- 50: photoelectric conversion section
- 60, 70: metal electrode
- 80: wiring member
- 91, 92: protection member
- 95: encapsulant
- 96, 97: electroconductive material (conductive film)
- 100: solar cell
- 200: solar cell module

## Claims

1. A solar cell wiring member for electrically connecting a plurality of solar cells, the wiring member is band-shape and having a first principal surface and a second principal surface, wherein
at a part of the first principal surface connected to the solar cell, the wiring member has a plurality of projected parts that are triangular in cross section, and
the plurality of projected parts provided on the first principal surface extends parallel, and an extending direction of each of the plurality of projected parts is non-parallel to a longitudinal direction of the wiring member.

2. The solar cell wiring member according to claim 1, wherein the wiring member has the projected parts over an entire surface of the first principal surface.

3. The solar cell wiring member according to claim 1 or 2, wherein an angle φ made by the extending direction of each of the projected parts and the longitudinal direction of the wiring member is 40° to 90°.

4. The solar cell wiring member according to any one of claims 1 to 3, wherein each of the projected parts has an isosceles triangle cross-sectional shape in a plane perpendicular to the extending direction.

5. The solar cell wiring member according to any one of claims 1 to 4, wherein an elevation angle θ of a slope of each of the projected parts is 20° to 40°.

6. The solar cell wiring member according to any one of claims 1 to 5, wherein
the second principal surface also has a plurality of projected parts each having a triangular in cross section, and
the plurality of projected parts provided on the second principal surface extends parallel, and an extending direction of each of the plurality of projected parts is non-parallel to a longitudinal direction of the wiring member.

7. The solar cell wiring member according to claim 6, wherein the extending direction of each of the plurality of projected parts provided on the first principal surface is parallel to the extending direction of each of the plurality of projected parts provided on the second principal surface.

8. The solar cell wiring member according to claim 6, wherein the extending direction of each of the plurality of projected parts provided on the first principal surface and the extending direction of each of the plurality of projected parts provided on the second principal surface are non-parallel, and symmetrical with respect to the longitudinal direction of the wiring member.

9. A solar cell module comprising a plurality of solar cells each having a metal electrode on a light-receiving surface and a back surface, the plurality of solar cells being electrically connected by a wiring member, wherein
a back-side metal electrode of each of the solar cells is connected via a conductive film to a first principal surface of the wiring member according to any one of claims 1 to 8, wherein the first principal surface of the wiring member is provided with projected parts.

10. A solar cell module comprising a plurality of solar cells each having a metal electrode on a light-receiving surface and a back surface, the plurality of solar cells being electrically connected by a wiring member, wherein
a light-receiving-side metal electrode of each of the solar cells and a back-side metal electrode of each of the solar cells are respectively connected via a conductive film to a projected part formed surface of the wiring member according to any one of claims 6 to 8.

11. The solar cell module according to claim 10, wherein the extending direction of each of the plurality of projected parts provided on the first principal surface of the wiring member is parallel to the extending direction of each of the plurality of projected parts provided on the second principal surface of the wiring member.

12. A solar cell module comprising a plurality of solar cells each having a metal electrode on a light-receiving surface and a back surface, the plurality of solar cells being electrically connected by a wiring member, wherein
a light-receiving-side metal electrode or back-side metal electrode of each of the solar cells is connected to the first principal surface of the wiring member according to any one of claims 1 to 8 provided with projected parts, wherein the first principal surface of the wiring member is provided with projected parts, and
an electrode connected to the first principal surface of the wiring member has a linear shape extending parallel to the longitudinal direction of the wiring member, and an electrode width is 70% or less of a width of the wiring member.

13. The solar cell module according to claim 12, wherein the back-side metal electrode of each of the solar cells is connected to the first principal surface of the wiring member.
